# EUROPEAN PATENT APPLICATION

(11) **EP 3 467 520 A1**
(43) Date of publication of application: **10.04.2019**
(21) Application number: 17805922.6
(22) Date of filing: 17.05.2017
(51) Int. Cl.: G01R 1/22, H01F 27/02, H01F 27/04

(54) **THREE-PHASE CURRENT TRANSFORMER**

(30) Priority: 31.05.2016 ES 201630696 U
(71) Applicant: Smilics Technologies S.L., 08223 Terrassa (Barcelona) (ES)
(72) Inventor: PONS GONZALEZ, Bernat, 08223 Terrassa (ES); CELEMÍN GONZÁLEZ, Javier, 08223 Terrassa (ES)
(74) Representative: Ponti & Partners, S.L.P
(86) International application number: PCT/ES2017/070328
(87) International publication number: WO 2017/207838

(57) **Abstract**

The invention relates to a three-phase open-core current transformer, preferably for measurement applications, but which can also serve as electrical protection especially designed to be installed over a switch or other type of switchgear device, of those which are installed -generally temporarily- in an electrical installation, such as in a switchboard (where, for example, there are ammeters, energy meters, measurement stations, etc.), and the main function of which is that of measuring, sensing or analysing the current which passes through each cable of the electricity system without having to cut-off the electricity supply.

It is formed by a monoblock body which comprises three individual current sensors, and which is formed by two parts which can be separated from one another, so that it can be opened to be installed with great ease and speed by the operator in a switchboard of a three-phase electrical installation and thus be able to measure the electric current.

## Description

### Field of the invention:

The present invention relates to a three-phase open-core current transformer for applications preferably for measurement and it may additionally serve as electrical protection especially designed to be installed over a switch or another type of switchgear device, of those which are installed -generally temporarily- in an electrical installation, such as in a switchboard (where, for example, there are ammeters, energy meters, measurement stations, etc.), and the main function of which is that of measuring, sensing or analysing the current which passes through each cable of the electricity system without having to cut-off the electricity supply.

### State of the Art:

A current transformer is an instrument transformer (also called measurement or sensor), where the secondary current is, within the normal operating conditions, practically proportional to the primary current, and out of phase from it at an angle close to zero, for an appropriate direction of connections.

The primary of said transformer is electromagnetically coupled to the circuit one wants to control, whilst the secondary is connected to the current circuits of one or several measuring apparatus, relays or similar apparatus, connected in series.

A current transformer may have one or several secondary windings coiled on one or several separate magnetic circuits.

The factors that determine the selection of the current transformers are:
- The type of current transformer.
- The type of installation.
- The type of insulation.
- The nominal power.
- The accuracy class.
- The type of connection.
- The primary nominal current.
- The secondary nominal current.

The following exist within the types of current instrument transformer: (i) open-core (also called "split core") and (ii) those of closed core. The present invention centres on an open-core current instrument transformer.

This type of current transformers called open-core or split core do not have primary winding. It generally has reduced dimensions that facilitate its installation, since the iron core can open, facilitating its installation, since it is not necessary to disconnect cables or busbars for connection of the transformers. Thus, this type of transformers can be installed and uninstalled in compact switchboards, wherein the little available space makes it difficult to make current measurements with other types of devices. Furthermore, the fact that it is an open-core transformer allows making measurements without having to disconnect the electricity supply and with a great ease of installation and uninstallation in a very short period of time.

In general, the current measurement range that can be measured by this type of open-core current transformers may include a wide spectrum of intensities (e.g. from 1A to 20,000A), and also the maximum admissible cable diameter is also characterized by the current measurement, which may generally vary between 10 mm and 80 mm; or much higher for high currents.

Today, there are single-phase open-core current transformers, i.e. they are disposed in a cable of a single-phase installation.

### Object of the invention:

The object of the present invention is to devise a three-phase open-core current transformer especially designed to be installed over a switchgear device which is compact, which can be quickly installed and uninstalled by the operator, and especially when there is little space in the switchboard to be able to position it.

### Description of the invention:

The object of the present invention is that defined in claim 1.

The invention is materialized in a three-phase open-core current transformer of monoblock body, which comprises three individual current sensors, which is particularized as it is configured by two parts which can be separated from one another so that it can be detached and opened to be installed with great ease and speed by the operator in a switchboard of a three-phase electrical installation and thus be able to measure the current and also open to be again uninstalled.

Thus, the three-phase open-core current transformer of the invention comprises two parts which can be separated from one another, so that is can be detached by at least one of its ends, and it can be opened to be able to separate both halves and thus the operator can pass through the corresponding cables inside the orifices of the monoblock body, and re-close the two parts one against the other so that the transformer closes and it can then function.

Both parts are externally configured by surrounding casing, within which are disposed the individual current sensors, each part having an inner surface whereon three half-moon openings have been disposed, so that on joining both parts by their respective inner faces three orifices are formed with the two halves of each part.

The two separable parts that configure the transformer of the invention can be detached by at least one of their ends to be able to open 180°, although in a second embodiment of the present invention it is provided that both separable parts can completely separate from one another by the provision of two fastening means, one through each of their side faces, to facilitate their assembly and dismantling in sites where the switchboard almost does not leave free space so that the operator can install the transformer of the invention, or when it is complex to make modifications, or it is not possible to intervene the electrical infrastructure.

In relation to the current signal sensors, the holder of the invention has performed numerous field tests and has proven that it is possible to satisfactorily use various types of sensors or transducers for said purpose. As an illustrative but non limiting example, in relation to current signal sensors, it is possible to adequately use at least one, more than one, or a combination of the following types of sensors in their open-core variant:
- air core (Rogowski coil),
- iron core,
- ferrite core,
- nanocrystalline core,
- optical,
- magnetoresistive,
- Hall effect,
- zero flux current sensors, and/or
- hybrids.

The closing and opening means of both parts are configured by a first attachment point of the two parts between one another and an opposite second attachment point, so that one of the parts of the transformer can be opened with respect to the other part detaching the opposite second attachment point, and with the rotation axis being parallel to the axis of the transformer's orifices. Optionally, the first attachment point can be a fixed point (i.e. only of articulation) or it can also comprise closing and opening means between both parts, so that the two halves can be totally separated from one another.

According to a preferred embodiment of the invention, each inner face of each half has a plurality of current sensors (for example, magnetic elements) coinciding with one another, to ensure the closure of the two halves between one another.

Said three-phase open-core current transformer is anticipated to work preferably in the ranges of 0.1 A and 20000 A. As non-limiting example, the preferred dimensions for a 125 A transformer are: cable through-diameter 15 mm and distance between centres 28 mm; and the preferred dimensions for a 250 A transformer are: cable through-diameter 26 mm and distance between centres 35.5 mm.

The main application of the present invention is to be installed in reduced spaces, preferably making use of the space there is on protection devices (such as magnetothermal or differential), and in installations that make it possible to stop the supply to install the transformers.

The three-phase open-core current transformer preferably for applications for measurement may also internally incorporate other sensors to measure other parameters, such as voltage.

This three-phase open-core current transformer may additionally have fastening means for increasing the closure safety of the two parts of the transformer, for example, formed by receptacles provided in the two parts of the transformer, adapted so that on closing the receptacles of each part of the transformer coincide, and said receptacles being configured to receive in their interior respective set screws.

Hence, this current transformer has multiple advantages, among which we can highlight its great compactness, its reduced dimensions, its convenience and ease of installation by the user, and its reduced manufacturing cost, since it only requires a single compact product to measure the three electric cables of a three-phase installation, and not three individual products (one for each cable).

These and other characteristics shall be better gathered from the detailed description which follows which, to facilitate its understanding, is accompanied by five sheets of drawings, wherein a practical case of embodiment has been represented which is only cited by way of non-limiting example of the scope of the present invention.

### Description of the figures:

A list of the different figures is given below:
figure no. 1 illustrates a top perspective view of a preferred embodiment of the three-phase open-core current transformer of the invention;
figure no. 2 illustrates a bottom perspective view of said three-phase open-core current transformer of figure no. 1;
figure no. 3 illustrates a top plan view of said three-phase open-core current transformer of figure no. 1;
figure no. 4 illustrates a bottom plan view of said three-phase open-core current transformer of figure no. 1;
figure no. 5 illustrates an elevational view of said three-phase open-core current transformer of figure no. 1;
figure no. 6 illustrates a perspective view of said three-phase open-core current transformer of figure no. 1 in open position;
figure no. 7 illustrates a plan view of said three-phase open-core current transformer of figure no. 1 in totally open position;
figure no. 8 illustrates the same top plan view of figure no. 3 of said three-phase open-core current transformer, showing the three inner ferromagnetic cores;
figure no. 9 illustrates the same internal configuration of the three inner ferromagnetic cores as the previous figure no. 8 but in perspective, showing the U-shaped ferromagnetic cores and the winding in the upper part separated by respective walls;
figure no. 10 illustrates said three-phase open-core current transformer of figure no. 1 in perspective disposed in its working position situated in the upper part of a switchgear device and where the different electric cables have passed through said three orifices; and
figure no. 11 illustrates the same situation as previous figure no. 10 but in front elevation.

### Description of a preferred embodiment of the invention:

A possible practical embodiment of the invention, although not limitative, is that shown in the attached figures, wherein is observed a three-phase open-core current transformer (10) configured by a monoblock body which internally incorporates three current signal sensors, in this specific case it is three different magnetic cores and it has externally a surrounding casing of preferably plastic or resin material.

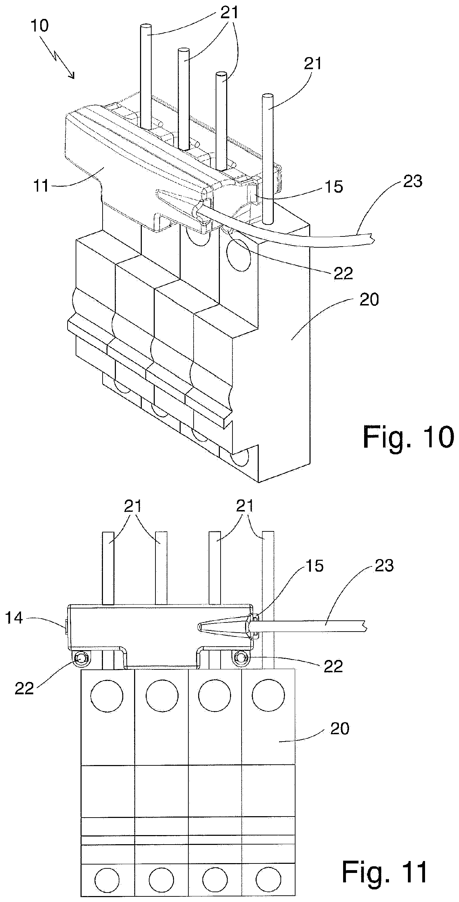

It is particularized by the fact that it is configured by two parts (11, 12) that can be separated from one another, so that an operator can open both parts (11, 12) to install the device with great ease and speed in a switchboard (20) already previously installed of a three-phase electrical installation, first opening the two parts (11, 12) of the transformer (10), then the operator making each corresponding electric cable (20) pass through the inside of each respective orifice (13) of the transformer (10), and finally closing both parts (11, 12) to thus be able to measure the current signals, without having to disconnect any electric cable (21) already connected to the switchboard (20) by their respective, plugs and/or terminals. In figures no. 10 and 11, the transformer of the invention is conveniently installed on a switchgear device.

Optionally, it is possible to increase the closure safety of the current transformer (10) by the provision of one or more receptacles (22) inside which are disposed respective set screws.

Said figures no. 10 and 11 also illustrate the outlet cable (23) of the transformer.

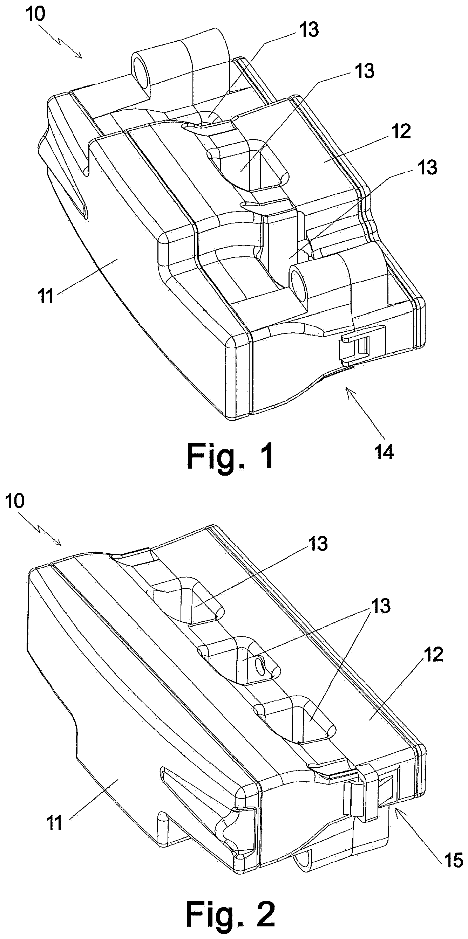

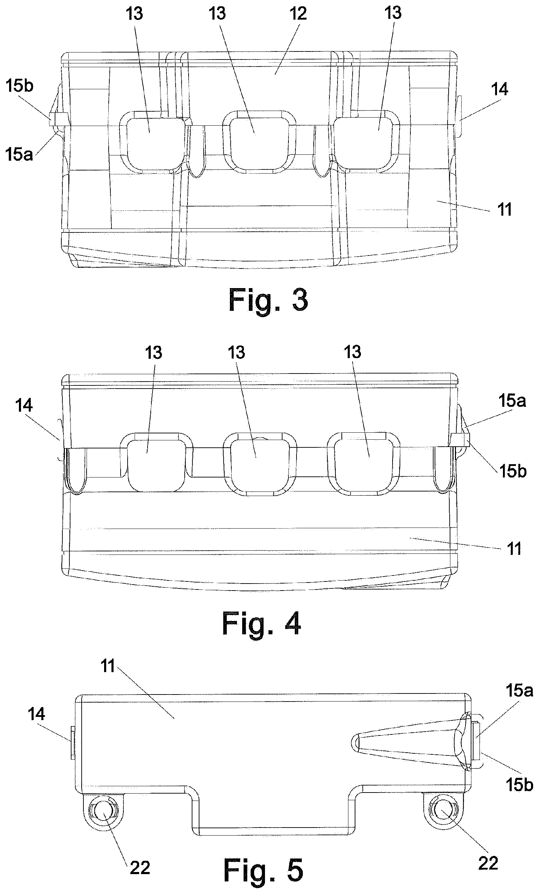

In the first figures no. 1 and 5, the outer configuration is shown of the transformer body in closed position, wherein the three through-holes (13) are seen and also the first attachment point of the two parts between one another (15) and the opposite second attachment point (14). In this specific case, both the first point (15) and the second point (14) comprise closing and opening means, so that both one and another point (14,15) can be opened one or another by the user, or keep both closed, depending on whether it is necessary due to the situation/location of the already installed switchboard.

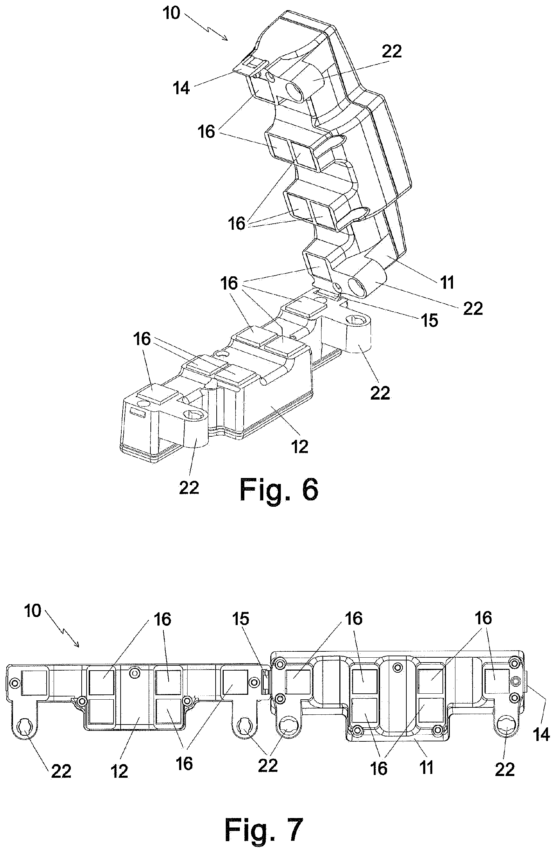

Figures no. 6 and 7 illustrate how the operator can open one of the parts (11) of the transformer with respect to the other part (12), both being joined by one of their points (15). In this example of embodiment, both fastening points (14,15) are formed by a clip-type attachment (15a) which on being pressed inwards can come out of a retaining ring (15b), see figures no. 3-5.

Figures no. 6 and 7 show the situation of the different ferromagnetic elements (16), which are present on the inner faces of both halves (11,12) and coincide with one another, so that each ferromagnetic element (16), when one half (11) is closed against the other (12), fits perfectly with the other half and the transformer can act.

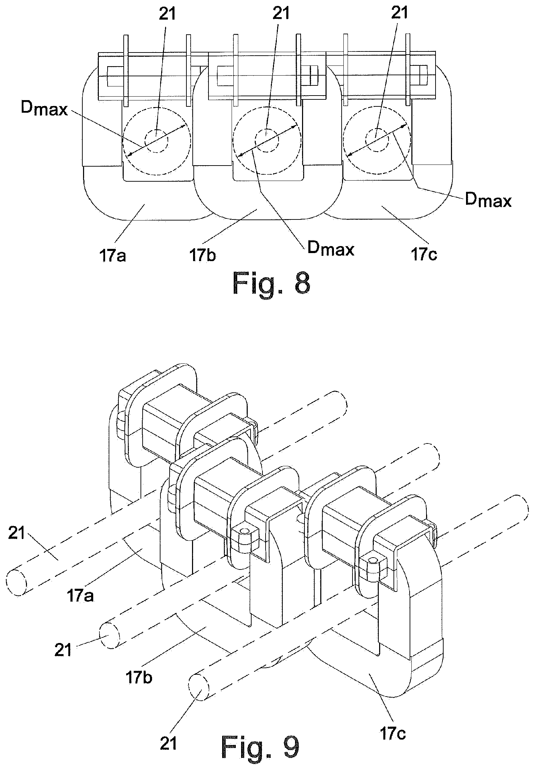

As regards figures no. 8 and 9, therein they represent the inside of the transformer (10), wherein it shows the open magnetic cores (17a, 17b, 17c), and it also shows a possible layout of the three electric cables (21) which run through the inside of each inner orifice of each magnetic core (17a, 17b, 17c). It has also represented the maximum cable diameter (indicated by Dmax) that said cores may house.

The invention, within its essential nature, can be put into practice in other forms of embodiment which differ in detail from that indicated only by way of example, which will also have the protection obtained. This three-phase current transformer can, therefore, be manufactured in any shape and size, with the most appropriate means and materials and with the most convenient accessories, and the different components of the invention can be replaced by others that are technically equivalent, as they are all included in the spirit of the following claims.

## Claims

1. Three-phase current transformer, of those of open-core type, preferably for applications for measurement and they may also additionally serve as electrical protection, especially designed to be installed in switchgear device, such as in switches, **characterized in that** it comprises:
externally a monoblock body which is configured by two parts opening between one another, so that the operator can detach and separate both halves to be able to pass the corresponding electric cables inside the orifices of the monoblock body and re-close the two parts one against the other;
internally three individual current sensors; and
externally opening means configured by a first attachment point of the two parts between one another and a opposite second attachment point, so that one of the parts of the transformer can be opened with respect to the other part detaching the opposite second attachment point, and with the rotation axis being parallel to the axis of the transformer's orifices.

2. Three-phase current transformer, according to claim 1, wherein both parts are completely separable with respect to the other.

3. Three-phase current transformer, according to any of the preceding claims, wherein the individual current sensors comprise at least one, or a combination of the following types of sensors in their open-core variant:
- air core (Rogowski coil),
- iron core,
- ferrite core,
- nanocrystalline core,
- optical,
- magnetoresistive,
- Hall effect,
- zero flux current sensors, and/or
- hybrids.

4. Three-phase current transformer, according to the preceding claim, wherein in the case that the individual current sensors comprise sensors of magnetic core type, each inner face of each part of the transformer comprises a plurality of distributed ferromagnetic elements, which are concordant with one another, so that when the two parts of the transformer close said ferromagnetic elements of each half coincide with one another.

5. Three-phase current transformer, according to any of the preceding claims, wherein it is anticipated to work in an intensity range between 0.1 A and 20000 A.

6. Three-phase current transformer, according to the preceding claim, wherein it has dimensions for a 125 A transformer of cable through-diameter 15 mm and distance between centres 28 mm.

7. Three-phase current transformer, according to claim 6, wherein it has dimensions for a 250 A transformer of cable through-diameter 26 mm and distance between centres 35.5 mm.

8. Three-phase current transformer, according to any of the preceding claims, wherein it has in each part of the transformer receptacles for increasing the safety of the closure of the two parts of the transformer one against the other, adapted so that when they close the receptacles of each part coincide, and are configured to receive set screws in their respective interiors.
